# EUROPÄISCHE PATENTSCHRIFT

(11) **EP 0 440 862 B1**
(45) Veröffentlichungstag und Bekanntmachung des Hinweises auf die Patenterteilung: **14.09.1994**
(21) Anmeldenummer: 90102513.0
(22) Anmeldetag: 08.02.1990
(51) Int. Cl.: H03K 17/94, H05B 37/02

(54) **Fernbedienbarer Lichtschalter bzw. Taster**
Remotely-controllable lightswitch or button
Bouton-poussoir ou interrupteur de lumière télécommandé

(43) Veröffentlichungstag der Anmeldung: 14.08.1991
(73) Patentinhaber: SIEMENS AKTIENGESELLSCHAFT, 80333 München (DE)
(72) Erfinder: Wimmer, Gerhard, Dipl.-Ing.(FH), D-8411 Waldetzenberg (DE); Kammerl, Franz, Dipl.-Ing.(FH), D-8411 Laaber Endlfeld (DE)

(56) Entgegenhaltungen:
- US-A- 4 344 071
- US-A- 4 663 521
- US-A- 4 768 020
- PATENT ABSTRACTS OF JAPAN Band 13, nr.117 (E-731)(3465) 22 März 1989 & JP-A-63289795
- ELEKTOR ELECTRONICS Band 12, Heft 1, Januar 1986, Seiten 19-21, London GB; P.Theunissen: "Infra-red light switch"

## Beschreibung

Die Erfindung bezieht sich auf einen fernbedienbaren Lichtschalter bzw. Taster nach Gattungsbegriff von Patentanspruch 1. Die Einschaltung wird von einem Objektsensor bei Empfang eines auf den Sensor abgestimmten Feldes ausgelöst. In den Ausschaltzustand zurückgesetzt wird durch ein Zeitglied verzögert. Derartige Schalter sind als Näherungsschalter auf dem Markt. Sie dienen zum Schalten von Beleuchtungsanlagen. Derartige Anlagen, wie sie z.B. aus PATENT ABSTRACTS OF JAPAN, Band 13, Nr. 117 (E-731) (3465) vom 22.03.1989 bekannt sind, weisen Lichtsensoren oder Dämmerungsschalter auf, die ein Einschalten nur unterhalb einer vorgegebenen Helligkeitsschwelle zulassen. Für einen einzelnen Näherungsschalter wird ein Nachschalten, also eine Verlängerung der Einschaltzeit durch erneutes Eintreten des Objektes in das Erfassungsfeld dadurch ermöglicht, daß der Dämmerungsschalter für die Zeit der Einschaltung funktionslos gemacht wird. Andernfalls würde der Dämmerungsschalter ein Nachschalten verhindern, da bei einer Helligkeit oberhalb der Einschaltschwelle ein Einschalten nicht möglich wäre.

Wenn mehrere Näherungsschalter in einer Beleuchtungsanlage angeordnet werden, kann zwar der zuerst einschaltende Näherungsschalter nachgeschaltet werden, jedoch nicht benachbarte Näherungsschalter in einer Gesamtanlage.

Der Erfindung liegt die Aufgabe zugrunde, einen fernbedienbaren Lichtschalter zu entwickeln, der auch in Anlagen mit zwei oder mehr fernbedienbaren Lichtschaltern ein Nachschalten auch dann ermöglicht, wenn das Licht von benachbarten Fernschaltern eingeschaltet wurde.

Die geschilderte Aufgabe wird durch einen fernbedienbaren Lichtschalter nach Patentanspruch 1 gelöst. Bei einer Anordnung von zwei oder mehr fernbedienbaren Lichtschaltern wird ein Nachschalten ermöglicht, wenn die fernbedienbaren Lichtschalter jeweils Mittel zum Erfassen von Helligkeitssprüngen aufweisen. Deren vom eingeschalteten Licht abgeleitete Befehlssignale werden dem Eingang des Zeitgliedes zugeführt, dessen Ausgang mit dem Inaktivierungsteil des Lichtsensors verbunden ist. Die Befehlssignale werden also vom eingeschalteten Licht abgeleitet, so daß von diesem Zeitpunkt an innerhalb der vom Zeitglied vorgegebenen Zeit ein Nachschalten eines fernbedienbaren Schalters bzw. Tasters auch dann möglich ist, wenn eine Beleuchtungsanlage von einem benachbarten fernbedienbaren Lichtschalter aus eingeschaltet wurde.

Das Erfassungsmittel kann den Potentialsprung am Ausgang des Dämmerungsschalters beim Einschalten der Beleuchtungsanlage von einem benachbarten fernbedienbaren Lichtschalter aus auswerten. Nach einem anderen Weg kann das Erfassungsmittel die Spannungsbeaufschlagung in einer Schaltleitung von Schaltstufen für Lampen einer Beleuchtungsanlage auswerten.

Der fernbedienbare Lichtschalter kann bei der Realisierung nach dem ersten Weg beispielsweise nach Patentanspruch 4 aufgebaut sein. Danach arbeitet der Lichtsensor des Dämmerungsschalters mit seinem Ausgang auf einen Schwellwertschalter, der mit einem Und-Glied verbunden ist, das mit einem weiteren Eingang mit dem Objektsensor in Verbindung steht. Dem Und-Glied ist ein Zeitglied nachgeschaltet, das Inaktivierungszeit für den Lichtsensor vorgibt. Zwischen dem Und-Glied und dem Zeitglied ist ein Oder-Glied zwischengeschaltet, an dessen einem weiteren Eingang der Ausgang eines dem Schwellwertschalter auch nachgeschalteten Impulsgebers für ein Triggersignal beim Abfall dessen Eingangssignals verbunden ist. Ein Arbeitssignal zur Betätigung einer Schaltstufe in der Beleuchtungsanlage wird zwischen dem Und-Glied und dem Oder-Glied abgenommen.

Nach dem zweiten Weg kann eine Realisierung beispielsweise nach Patentanspruch 5 erfolgen. Danach arbeitet der Lichtsensor des Dämmerungsschalters mit seinem Ausgang wieder auf einen Schwellwertschalter, der mit einem Und-Glied verbunden ist, das mit einem weiteren Eingang mit dem Objektsensor in Verbindung steht. Dem und-Glied ist wieder ein Zeitglied nachgeschaltet, das die Inaktivierungszeit für den Lichtsensor vorgibt. Zwischen Und-Glied und Zeitglied ist ein Oder-Glied zwischengeschaltet, mit dessen einem weiteren Eingang jedoch der Ausgang einer Überwachungseinrichtung verbunden ist, die eingangsseitig mit der Schaltleitung der Beleuchtungsanlage in Verbindung steht. Die Überwachungseinrichtung weist eine Detektionseinrichtung für Schaltspannung sowie eine Einrichtung zur Abgabe eines Triggersignals auf. Ein Arbeitssignal zur Betätigung einer Schaltstufe in der Schaltleitung der Beleuchtungsanlage kann zwischen dem Und-Glied und dem Oder-Glied abgenommen werden.

Nach dem ersten Weg wird das erwünschte Ergebnis der Schalthandlung zum Triggern der Zeit für eine Nachschaltung in fernbedienbaren Lichtschaltern bzw. Tastern genutzt, an denen die Schalthandlung nicht selbst vorgenommen wurde. Beim zweiten Weg wird indirekt eine Veränderung aufgrund der Schalthandlung in einem geschalteten fernbedienbaren Lichtschalter ausgewertet. Prinzipiell kann man feststellen, daß sich auf die erfindungsgemäße Weise fernbedienbare Schalter koppeln lassen, die von zwei Feldern unterschiedlicher Art beeinflußt werden, wobei eine Feldart durch die Schalter mittelbar zur Aussendung gebracht wird.

Bei einem erfindungsgemäßen fernbedienbaren Lichtschalter bzw. Taster in einer Beleuchtungsanlage braucht man beim Gang an einem ersten fernbedienbaren Lichtschalter vorbei beim Eintreten in das Erfassungsfeld eines zweiten fernbedienbaren Lichtschalters nicht zu warten, bis die Beleuchtungsanlage ausschaltet. Vielmehr kann man durch das automatische Nachschalten durch die Anwesenheit der Person im Erfassungsfeld des zweiten fernbedienbaren Lichtschalters durch Nachschalten die Beleuchtungszeit verlängern.

Die Erfindung soll nun anhand von in der Zeichnung grob schematisch wiedergegebenen Ausführungsbeispielen näher erläutert werden:

In FIG 1 ist ein fernbedienbarer Lichttaster veranschaulicht.
In FIG 2 ist ein Diagramm für signifikante Schaltzustände eines fernbedienbaren Lichttasters nach FIG 1 veranschaulicht.
In FIG 3 ist ein anderes Ausführungsbeispiel für einen fernbedienbaren Schalter in der Ausführung als Drei-Leiter-Taster wiedergegeben. Das Triggersignal wird hierbei wieder vom Dämmerungsschalter abgenommen.
In FIG 4 ist ein fernbedienbarer Lichttaster anderer Art dargestellt, bei dem das Triggersignal für die Nachschaltung von einer Überwachungseinrichtung der Schaltleitung gewonnen wird.
In FIG 5 ist ein weiteres Ausführungsbeispiel zum Lichttaster nach FIG 3 in der Ausführung als Zwei-Leiter-Schalter wiedergegeben.

Der fernbedienbare Lichtschalter 1 bzw. Taster weist einen Objektsensor 2, beispielsweise für Infrarotstrahlung und einen Lichtsensor 3 für einen Dämmerungsschalter 4 mit einem Schwellwertschalter 5 auf. Der fernbedienbare Lichtschalter 1 ist durch ein Zeitglied 6 verzögert in den Ausschaltzustand zurücksetzbar. Der Ausgang des Zeitgliedes 6 ist mit einem Inaktivierungsteil 7 des Lichtsensors 3 verbunden. Weiter sind Mittel zum Erfassen der Auswirkung von Helligkeitssprüngen vorgesehen, deren vom eingeschalteten Licht abgeleitete Befehlssignale dem Eingang des Zeitgliedes 6 zugeführt werden. Im Ausführungsbeispiel wertet das Erfassungsmittel den Potentialsprung am Ausgang des Dämmerungsschalters 4 aus. Das Erfassungsmittel ist im Ausführungsbeispiel der Zweig zwischen dem Ausgang 8 des Dämmerungsschalters 4 und dem Eingang des Zeitgliedes 6 zur Inaktivierung des Lichtsensors 3. Dieses Mittel zum Erfassen der Auswirkung von Helligkeitssprüngen leitet vom eingeschalteten Licht Befehlssignale ab, die dem Eingang des Zeitgliedes 6 zugeführt werden. Über den Ausgang des Zeitgliedes 6 werden sie dem Inaktivierungsteil 7 des Lichtsensors 3 weitergegeben.

Im einzelnen ist der Aufbau beispielsweise wie folgt:

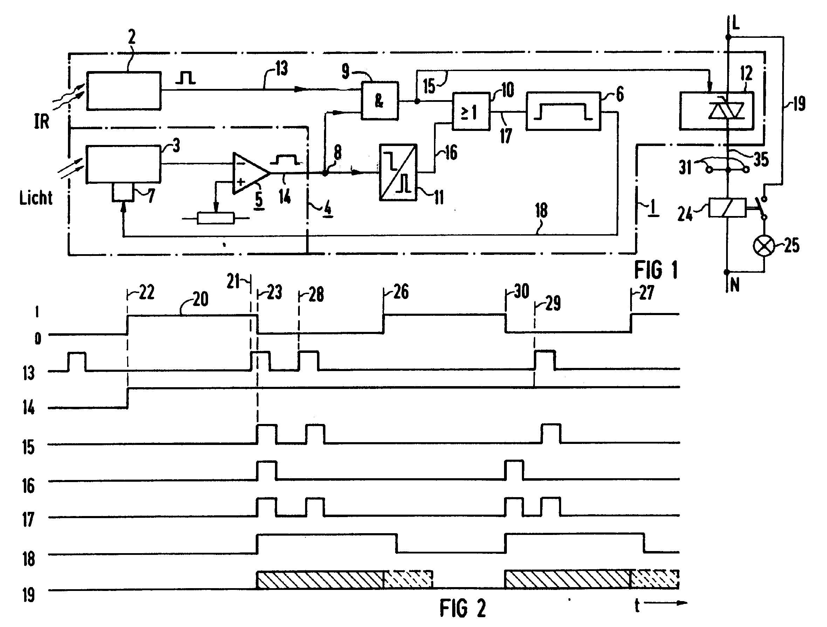

Der Ausgang des Schwellwertschalters 5 des Dämmerungsschalters 4 ist mit einem Und-Glied 9 ebenso verbunden wie ein Objektsensor 2. Dem Und-Glied 9 ist das Zeitglied 6 zur Inaktivierung des Lichtsensors 3 nachgeschaltet. Dieses gibt die Inaktivierungszeit für den Lichtsensor 3 vor. Zwischen dem Und-Glied 9 und dem Zeitglied 6 ist ein Oder-Glied 10 zwischengeschaltet, an dessen einen weiteren Eingang der Ausgang 8 eines dem Schwellwertschalter 5 auch nachgeschalteten Impulsbildners 11 für ein Triggersignal bei Abfall dessen Eingangssignals verbunden. Ein Arbeitssignal zur Betätigung einer Schaltstufe 12 in einer Beleuchtungsanlage wird zwischen dem Und-Glied 9 und dem Oder-Glied 10 abgenommen. Im einzelnen sind Leitungen 13 bis 19 besonders bezeichnet. Zu diesen Leitungen sind Schaltzustände im Diagramm nach FIG 2 grob schematisch veranschaulicht.

In FIG 2 sind Schaltzustände auf den Leitungen 13 bis 19 nach FIG 1 grob schematisch veranschaulicht. auf der Abszisse ist die Zeit und auf der Ordinate zu jeder Diagrammkurve ein Schaltzustand bzw. Spannungszustand veranschaulicht. Die Helligkeit in der Umgebung des fernbedienbaren Lichtschalters ist mit dem Verlauf 20 reziprok dargestellt. Im Schaltzustand "1" ist es dunkel und im Schaltzustand "0" ist es hell. Zum Zeitpunkt 21, bei dem es dunkel ist, betritt beispielsweise eine Person den Erfassungsbereich des Objektsensors 2, so daß der Leitung 13 ein Signalimpuls vom Objektsensor 2 zugeleitet wird. Seit dem Zeitpunkt 22, seit Beginn der Dunkelheit, steht am Ausgang des Schwellwertschalters 5 auf der Leitung 14 ein Signal an, so daß das Und-Glied 9 ein Signal abgibt, wenn vom Objektsensor 2 ein Objekt aufgrund von Infrarotstrahlung erkannt wird und ein Signal auf der Leitung 13 abgegeben wird. Mit einer veranschaulichten technisch bedingten Verzögerung steht zum Zeitpunkt 23 auf der Leitung 15 ein Arbeitssignal an, wenn das Und-Gatter 9 ein Signal abgibt. Das Signal auf der Leitung 15 wird als Arbeitssignal der Schaltstufe 12 zugeführt. Wenn die Beleuchtung zum Zeitpunkt 23 aufgrund des Arbeitssignals in der Leitung 15 eingeschaltet ist, gibt der Lichtsensor 3 über den Schwellwertschalter 5 ein Signal ab, sobald die Helligkeit den vorgegebenen Schwellwert übersteigt. In der Leitung 16 steht dann ein Signal hinter dem Impulsbildner an. Das Oder-Glied 10 führt dieses Signal dem Zeitglied 6 zu, so daß das Zeitglied erneut in Gang gesetzt wird. Zu diesem Zeitpunkt werden durch die eingeschaltete Beleuchtung auch die Zeitglieder in benachbarten fernbedienbaren Lichtschaltern erstmalig in Gang gesetzt, ohne daß ihr Objektsensor 2 ein Signal abzugeben braucht. Gleichgültig ob das Zeitglied 6 vom Objektsensor 2 oder vom Lichtsensor 3 her getriggert wurde, führt dann die Leitung 18 zwischen Zeitglied 6 und Inaktivierungsteil 7 des Lichtsensors 3 ein Signal bis zum Zurücksetzen des Zeitglieds 6.

Wenn die Schaltstufe 12 mit der Funktion eines Tasters durch das Arbeitssignal auf der Leitung 15 eingeschaltet wird, schließt der Zeitschalter 24 in der Beleuchtungsanlage mit der symbolisch wiedergegebenen Lampe 25 die Versorgungsleitung 19 der Lampe 25 solange, bis der Zeitschalter 24 abschaltet und die Versorgungsleitung 19 zwischen dem Außenleiter L bzw. dem Phasenleiter und dem N-Leiter unterbricht. Dies erfolgt jeweils zu Zeitpunkten 26 und 27 der Lichtabschaltung. Zu Zeitpunkten 28 und 29 ist ein Nachschalten veranschaulicht. Dabei ist zum Zeitpunkt 28 das Nachschalten durch einen fernbedienbaren Lichtschalter veranschaulicht, der durch seinen Objektsensor beim Zeitpunkt 23 eingeschaltet wurde. Zum Zeitpunkt 29 ist eine Nachschaltung bei einem fernbedienbaren Lichtschalter veranschaulicht, der zum Zeitpunkt 30 der Lichteinschaltung von seinem Objektsensor 2 kein Arbeitssignal gewinnt.

Weitere Schaltstufen 12 von Beleuchtungsanlagen können über Anschlußleitungen 31 für weitere Schaltstufen angeschlossen werden.

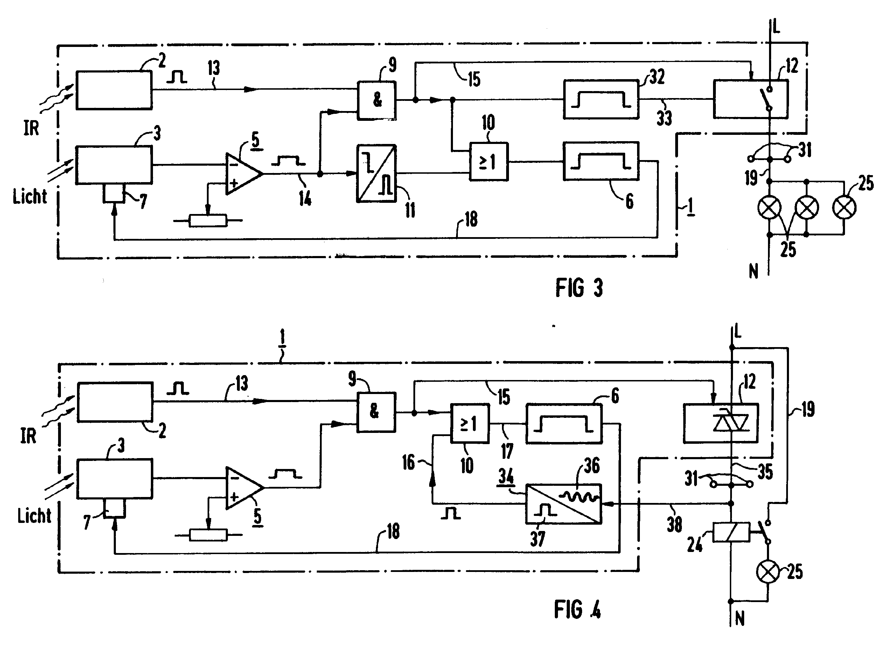

Im Ausführungsbeispiel für den fernbedienbaren Lichtschalter 1 nach FIG 3 wird die Funktion des Zeitschalters durch ein Zeitglied 32 für die Beleuchtungsdauer im fernbedienbaren Lichtschalter integriert. Wiedergegeben ist ein als Drei-Leiter-Taster ausgeführter Lichtschalter. Über die Leitung 15 wird der Schaltstufe 12 wieder das Arbeitssignal zugeführt. Über eine Leitung 33 wird jedoch vom Zeitglied 32 für die Beleuchtungsdauer für die Aktivierungszeit des Zeitglieds 32 ein Haltesignal zugeleitet. Für die Dauer des Haltesignals ist die Schaltstufe 12 leitend, so daß Lampen 25 für diese Dauer eingeschaltet sind. Weitere fernbedienbare Lichtschalter können über Anschlußleitungen 31 angeschlossen werden.

Beim fernbedienbaren Lichtschalter nach FIG 4 wird das Triggersignal für die Zeitdauer der Nachschaltung von einer Überwachungseinrichtung 34 der Schaltleitung 35 gewonnen. Die Überwachungseinrichtung 34 ist eingangsseitig mit der Schaltleitung 35 über die Meßleitung 38 verbunden. Sie weist eine Detektionseinrichtung 36 für Schaltspannung und eine Einrichtung 37 zur Abgabe eines Triggersignals für das Zeitglied 6 zur Vorgabe der Inaktivierungszeit des Lichtsensors 3 auf.

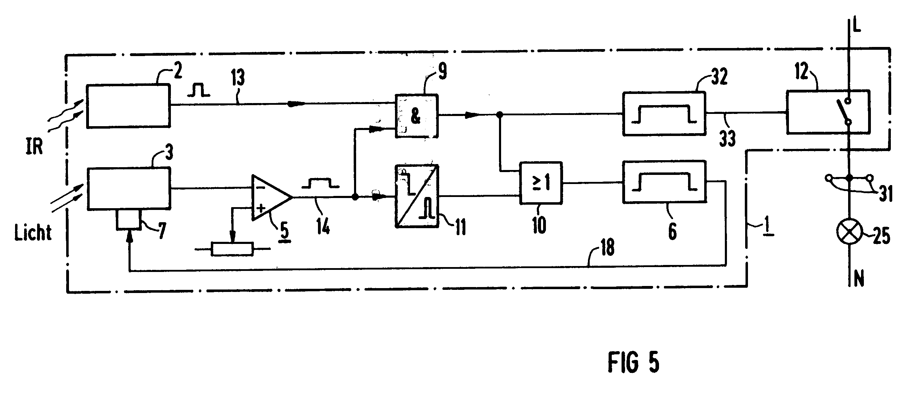

Im Ausführungsbeispiel nach FIG 5, das weitgehend dem nach FIG 3 entspricht, wird das Arbeitssignal für die Schaltstufe 12 über eine Leitung 33 zugeführt, die zugleich das Haltesignal übermittelt. Die Schaltstufe 12 ist so ausgelegt, daß sie so lange leitend geschaltet ist, wie das Zeitglied 32 für die Beleuchtungsdauer ein Signal zuführt. Diese Ausführung kann von der Funktion her als klassischer Schalter verstanden werden.

## Patentansprüche

1. Fernbedienbarer Lichtschalter (1) bzw. Taster mit einem Näherungsschatter, dessen Einschaltung von einem Objektsensor (2) bei Empfang eines auf den Sensor abgestimmten Feldes ausgelöst wird und der durch ein Zeitglied (6) verzögert in den Ausschaltzustand zurücksetzbar ist, wobei der Näherungsschalter zum Schalten einer Beleuchtungsanlage einen Lichtsensor (3) für einen Dämmerungsschalter (4) aufweist, der ein Einschalten der Beleuchtungsanlage nur unterhalb einer vorgegebenen Helligkeitsschwelle zuläßt, und der ein Nachschalten dadurch ermöglicht, daß der Dämmerungsschalter (4) für die Zeit der Einschaltung durch ein Inaktivierungsteil (7) funktionslos geschaltet wird, **dadurch gekennzeichnet,** daß zumindest ein Mittel (5, 11, 10 ; 38, 34, 10) zum Erfassen der Auswirkung von zu Helligkeitssprüngen führenden Einschaltvorgängen der Beleuchtungsanlage und Abgabe eines daraus abgeleiteten Befehlssignals an den Eingang des Zeitgliedes (6) vorgesehen ist, dessen Ausgang mit dem Inaktivierungsteil (7) des Lichtsensors (3) verbunden ist.

2. Fernbedienbarer Lichtschalter nach Anspruch 1, **dadurch gekennzeichnet,** daß das Erfassungsmittel den Potentialsprung am Ausgang des Dämmerungsschalters (4) auswertet.

3. Fernbedienbarer Lichtschalter nach Anspruch 1, **dadurch gekennzeichnet,** daß das Erfassungsmittel die Spannungsbeaufschlagung in einer Schaltleitung (35) von Schaltstufen (12) für Lampen (25) einer Beleuchtungsanlage auswertet (FIG 4).

4. Fernbedienbarer Lichtschalter nach Anspruch 2, **dadurch gekennzeichnet,** daß der Lichtsensor (3) des Dämmerungsschalters (4) mit seinem Ausgang auf einen Schwellwertschalter (5) arbeitet, der mit einem Und-Glied (9) verbunden ist, das mit einem weiteren Eingang mit dem Objektsensor (2) in Verbindung steht, wobei dem Und-Glied (9) das Zeitglied (6) nachgeschaltet ist, das die Inaktivierungszeit für den Lichtsensor (3) vorgibt, und daß zwischen Und-Glied (9) und Zeitglied (6) ein Oder-Glied (10) zwischengeschaltet ist, an dessen einem weiteren Eingang der Ausgang (8) eines dem Schwellwertschalter (5) auch nachgeschalteten Impulsbildners (11) für ein Triggersignal bei Abfall dessen Eingangssignals verbunden ist, und daß ein Arbeitssignal zur Betätigung einer Schaltstufe (12) in der Beleuchtungsanlage am Ausgang des Und-Gliedes (9) abgenommen wird.

5. Fernbedienbarer Lichtschalter nach Anspruch 3, **dadurch gekennzeichnet,** daß der Lichtsensor (3) des Dämmerungsschalters mit seinem Ausgang auf einen Schwellwertschalter (5) arbeitet, der mit einem Und-Glied (9) verbunden ist, das mit einem weiteren Eingang mit dem Objektsensor (2) in verbindung steht, wobei dem Und-Glied (9) das Zeitglied (6) nachgeschaltet ist, das Inaktivierungszeit für den Lichtsensor (3) vorgibt, und daß zwischen Und-Glied (9) und Zeitglied (6) ein Oder-Glied (10) zwischengeschaltet ist, mit dessen einem weiteren Eingang der Ausgang einer Überwachungseinrichtung (34) verbunden ist, die eingangsseitig mit der Schaltleitung (35) der Beleuchtungsanlage in Verbindung steht und eine Detektionseinrichtung (36) für die Schaltspannung sowie eine Einrichtung (37) zur Abgabe eines Triggersignals aufweist, und daß ein Arbeitssignal zur Betätigung einer Schaltstufe (12) in der Schaltleitung der Beleuchtungsanlage am Ausgang des Und-Gliedes (9) abgenommen wird.

## Claims

1. Remotely controllable light switch (1), or push-button with a proximity switch, the switching-on of which is triggered by an object sensor (2) when a field tuned to the sensor is received and which after a delay can be returned to the switched-off state by a timing element (6), with the proximity switch having, for the purpose of operating a lighting installation, a light sensor (3) for a twilight switch (4) that allows the lighting installation to be switched on only when the intensity of light falls below a specified threshold, and which makes subsequent switching possible by rendering the twilight switch (4) inactive for the switched-on period by means of a deactivation component (7), characterised in that at least one means (5, 11, 10; 38, 34, 10) is provided to detect the effect of command signals, derived in respect of sudden changes in light intensity, at the input of the timing element (6), the output of which is connected to the deactivation component (7) of the light sensor (3).

2. Remotely controllable light switch in accordance with claim 1, characterised in that the detecting means evaluates the sudden change in potential at the output of the twilight switch (4).

3. Remotely controllable light switch in accordance with claim 1, characterised in that the detecting means evaluates the voltage application in a switching line (35) of switching stages (12) for lamps (25) of a lighting installation (Fig. 4).

4. Remotely controllable light switch in accordance with claim 2, characterised in that the output of the light sensor (3) of the twilight switch (4) operates on a threshold value switch (5) connected to an AND-element (9) which with another input communicates with the object sensor (2), with the timing element (6) which presets the deactivation period for the light sensor (3) being connected downstream of the AND-element (9); and in that inserted between the AND-element (9) and the timing element (6) there is an OR-element (10), to the one further input of which the output (8) of a pulse generator (11) (also connected downstream of the threshold value switch (5)) is connected for a trigger signal when the latter's input signal decreases; and in that a working signal for actuating a switching stage (12) in the lighting installation is taken off at the output of the AND-element (9).

5. Remotely controllable light switch in accordance with claim 3, characterised in that the output of the light sensor (3) of the twilight switch operates on a threshold value switch (5) connected to an AND-element (9) which with another input communicates with the object sensor (2), with the timing element (6) which presets the deactivation period for the light sensor (3) being connected downstream of the AND-element (9); and in that inserted between the AND-element (9) and the timing element (6) there is an OR-element (10), connected to the one further input of which there is the output of a monitoring device (34), which communicates on the input side with the switching line (35) of the lighting installation and which has a detection device (36) for the switching voltage and also a device (37) to emit a trigger signal; and in that a working signal for actuating a switching stage (12) in the switching line of the lighting installation is taken off at the output of the AND-element (9).

## Revendications

1. Commutateur d'éclairage (1) ou bouton-poussoir télécommandé, comportant un interrupteur de proximité, dont la fermeture est déclenchée par un détecteur d'objet (2) lors de la réception d'un champ réglé sur le détecteur et qui peut être ramené à l'état ouvert, d'une manière retardée par une minuterie (6), l'interrupteur de proximité comportant, pour la commutation d'une installation d'éclairage, un détecteur de lumière (3) pour un interrupteur crépusculaire (4), qui n'autorise le branchement de l'installation d'éclairage qu'au-dessous d'un seuil de luminosité préscrit et qui permet un branchement ultérieur par le fait que l'interrupteur crépusculaire (4) est mis hors service, pendant la durée du branchement, par un élément de désactivation (7), caractérisé par le fait qu'il est prévu au moins un moyen (5, 11, 10; 38, 34, 10) de détection de l'effet d'opérations de branchement de l'installation d'éclairage, donnant des variations brusques de la luminosité, et d'envoi d'un signal d'instruction, qui en est dérivé, à l'entrée de la minuterie (6), dont la sortie est reliée à l'élément de désactivation (7) du capteur de lumière (3).

2. Commutateur d'éclairage télécommandé suivant la revendication 1, caractérisé par le fait que le moyen de détection exploite la variation brusque de potentiel à la sortie de l'interrupteur crépusculaire (4).

3. Commutateur d'éclairage télécommandé suivant la revendication 1, caractérisé par le fait que le moyen de détection exploite l'application de tension dans une ligne de commutation (35) d'étages de commutation (12) pour des lampes (25) d'une installation d'éclairage (figure 4).

4. Commutateur d'éclairage télécommandé suivant la revendication 2, caractérisé par le fait que la sortie du détecteur de lumière (3) de l'interrupteur crépusculaire (4) agit sur un commutateur à valeur de seuil (5), qui est relié à un circuit ET (9) dont une autre entrée est reliée au détecteur d'objet (2), la minuterie (6), qui prescrit la durée de désactivation du détecteur de lumière (3) étant branchée en aval du circuit ET (9), et qu'entre le circuit ET (9) et la minuterie (6) est intercalé un circuit OU (10), à une autre entrée duquel est connectée la sortie (8) d'un dispositif de formation d'impulsions (11), qui est également branché en aval du commutateur à valeur de seuil (5) et qui sert à envoyer un signal de déclenchement lors de la retombée de son signal d'entrée, et qu'un signal de travail servant à actionner un étage de commutation (12) dans l'installation d'éclairage est prélevé sur la sortie du circuit ET (9).

5. Commutateur d'éclairage télécommandé suivant la revendication 3, caractérisé par le fait que la sortie du détecteur de lumière (9) de l'interrupteur crépusculaire agit sur un commutateur à valeur de seuil (5), qui est relié à un circuit ET (9) et dont une autre entrée est connectée au détecteur d'objet (2), la minuterie (6), qui prescrit la durée de désactivation du détecteur de lumière (3), étant branchée en aval du circuit ET (9), et qu'entre le circuit ET (9) et la minuterie (6) est intercalé un circuit OU (10), à une autre entrée duquel est reliée la sortie d'un dispositif de contrôle (34), qui est raccordé, côté entrée, à la ligne de commutation (35) de l'installation d'éclairage et qui comporte un dispositif (36) de détection de la tension de commutation et un dispositif (37) d'envoi d'un signal de déclenchement, et qu'un signal de travail destiné à actionner un étage de commutation (12) dans la ligne de commutation de l'installation d'éclairage est prélevé à la sortie du circuit ET (9).
